# EUROPÄISCHE PATENTSCHRIFT

(11) **EP 2 380 061 B1**
(45) Veröffentlichungstag und Bekanntmachung des Hinweises auf die Patenterteilung: **06.12.2017**
(21) Anmeldenummer: 09801667.8
(22) Anmeldetag: 21.12.2009
(51) Int. Cl.: G03F 7/00, G02B 1/04, G02B 3/00, G02B 5/00, G02B 5/32, G03F 7/004

(54) **VERFAHREN ZUR HERSTELLUNG OPTISCHER ELEMENTE MIT GRADIENTENSTRUKTUR UND OPTISCHES ELEMENT MIT GRADIENTENSTRUKTUR**
METHOD FOR PRODUCING OPTICAL ELEMENTS HAVING A GRADIENT STRUCTURE AND OPTICAL ELEMENT HAVING A GRADIENT STRUCTURE
PROCÉDÉ POUR LA FABRICATION D'ÉLÉMENTS OPTIQUES AYANT UNE STRUCTURE EN GRADIENT ET ÉLÉMENT OPTIQUE AYANT UNE STRUCTURE EN GRADIENT

(30) Priorität: 22.12.2008 DE 102008064168
(43) Veröffentlichungstag der Anmeldung: 26.10.2011
(73) Patentinhaber: Leibniz-Institut für Neue Materialien gemeinnützige GmbH, 66123 Saarbrücken (DE)
(72) Erfinder: DE OLIVEIRA, Peter William, 66123 Saarbrücken (DE); VEITH, Michael, 66386 St.-Ingbert (DE); KÖNIG, Peter, 66822 Lebach (DE); KAMPKA, Jenny, 66806 Ensdorf (DE); KRAEGELOH, Annette, 66440 Blieskastel-Brenschelbach (DE)
(74) Vertreter: Patentanwälte Gierlich & Pischitzis Partnerschaft mbB
(86) Internationale Anmeldenummer: PCT/EP2009/009177
(87) Internationale Veröffentlichungsnummer: WO 2010/072390

(56) Entgegenhaltungen:
- WO-A2-2008/127401
- DE-A1-102004 061 323
- DE-A1-102004 061 324
- US-A1- 2004 027 625
- US-A1- 2005 008 762

## Beschreibung

### Gebiet der Erfindung

Die Erfindung betrifft ein Verfahren zur Herstellung optischer Elemente mit Gradientenstruktur, insbesondere für holographische Anwendungen, wobei die Gradientenstruktur durch einen Brechzahlgradienten gebildet wird, sowie ein optisches Element mit einer solchen Gradientenstruktur.

### Stand der Technik

Aus dem Stand der Technik sind Zusammensetzungen bekannt, welche das Einbringen von biologischen Polymeren, insbesondere von DNA in eine organische Matrix beschreiben. In den meisten Fällen mit dem Ziel in irgendeiner Weise die in der DNA enthaltene Sequenzinformation zu nutzen. So beschreibt die Druckschrift US 2005-0008762 das Einbringen von DNA in einer Polymermatrix zum Schutz vor Fälschungen. WO 2008-004203 nutzt die Sequenzspezifität der DNA zur lokalen Aufbringung eines Farbstoffs, welcher dann die lokale Bildung einer optischen Information, unter anderem auch eines Hologramms, begünstigt.

DE 10 2004 061 323 A1 beschreibt die Herstellung eines optischen Bauteils, indem ein anorganisch-organisches Hybridmaterial auf ein Substrat aufgetragen und selektiv bestrahlt wird.

DE 10 2004 061 324 A1 beschreibt die Herstellung eines optischen Bauteils, indem ein anorganisch-organisches Hybridmaterial mit oberflächenmodifizierten nanoskaligen Teilchen auf ein Substrat aufgetragen und selektiv bestrahlt wird.

US 2004/027625 A1 beschreibt die Herstellung eines mehrfach beschreibbaren holographischen Speichermediums, wobei das Speichermedium eine reversibel polymerisierbare Schreibkomponente und eine Matrixkomponente beinhaltet. Die Schreibkomponente kann Nukleotide wie DNA und RNA umfassen.

### Aufgabe

Aufgabe der Erfindung ist es, ein Verfahren anzugeben, welche die Herstellung von optischen Elementen ermöglichen.

### Lösung

Diese Aufgabe wird durch die Erfindungen mit den Merkmalen der unabhängigen Ansprüche gelöst. Vorteilhafte Weiterbildungen der Erfindungen sind in den Unteransprüchen gekennzeichnet. Der Wortlaut sämtlicher Ansprüche wird hiermit durch Bezugnahme zum Inhalt dieser Beschreibung gemacht. Wie in den Ansprüchen definiert,umfasst die Erfindung alle möglichen Kombinationen von Merkmalen. Die Aufgabe wird insbesondere durch ein Verfahren gelöst. Im Folgenden werden einzelne Verfahrensschritte näher beschrieben. Die Schritte müssen nicht notwendigerweise in der angegebenen Reihenfolge durchgeführt werden, und das zu schildernde Verfahren kann auch weitere, nicht genannte Schritte aufweisen.
In einem ersten Schritt wird eine Zusammensetzung aus einem oder mehreren polymerisierbaren oder polykondensierbaren Monomeren und mindestens einem biologischen Polymer hergestellt, wobei das biologische Polymer in einer in der Zusammensetzung löslichen Form vorliegt.
Unter einem biologischen Polymer im Sinne der Erfindung versteht man natürlich vorkommende Polymere, wie z.B. (Desoxy)Ribonukleinsäuren (DNA oder RNA), Polypeptide oder Proteine. Diese Polymere müssen allerdings in keiner Weise aus natürlichen Organismen stammen oder eine aus der Natur bekannte Sequenz aufweisen. Des Weiteren umfasst ein biologisches Polymer im Sinne der Erfindung auch von den vorstehend genannten Polymeren abgeleitete Polymere. Dabei kann es sich um geringfügige Modifikationen, wie Alkylierungen oder Substitutionen, aber auch um davon abgeleitete Systeme, wie Peptide Nucleic Acids (PNA) oder Peptide aus β-Aminosäuren handeln. Das biologische Polymer kann in beliebigen Konformationen und/oder Strukturen vorliegen.

In einem weiteren Schritt wird eine Potentialdifferenz zur gerichteten Diffusion der Monomere unter Bildung eines Brechzahlgradienten durch Induzierung einer lokalen Polymerisation oder Polykondensation erzeugt.

Bei der Potentialdifferenz wird vorzugsweise eine chemische Potentialdifferenz erzeugt, beispielsweise analog dem nachfolgend beschriebenen Colburn-Haines-Effekt, der auf folgendem Mechanismus beruht: Bei einer lokalen induzierten Polymerisation oder Polykondensation von Spezies mit polymerisierbaren oder polykondensierbaren Gruppen, wie z. B. Kohlenstoff-Kohlenstoff-Mehrfachbindungen oder Epoxid-Ringen, führt die Polymerisation oder Polykondensation zu einer Verarmung an polymerisierbaren oder polykondensierbaren Gruppen in den Bereichen, in denen die Polymerisation oder Polykondensation stattfindet. Dies führt zu einer gerichteten Diffusion von Monomeren mit noch nicht reagierten polymerisierbaren oder polykondensierbaren Gruppen in die Bereiche, in denen die Polymerisation oder Polykondensation stattfindet, bzw. stattgefunden hat, um die chemische Potentialdifferenz auszugleichen. Diese Monomere stehen in diesen Bereichen zur Polymerisation zur Verfügung. Dies führt in diesen Bereichen zu einer Veränderung der optischen Dichte und somit zu einer lokalen Erhöhung oder Erniedrigung der Brechzahl.

Die vorstehend verwendeten Ausdrücke "Polymerisation" und "polymerisierbar" schließen auch die Polyaddition und polyadditionsfähige Gruppen ein.

Überraschenderweise wurde gefunden, dass sich aus einer Zusammensetzung aus einem oder mehreren polymerisierbaren und/oder polykondensierbaren Monomeren und mindestens einem biologischen Polymer auf einfache Weise stabile und hochwertige optische Elemente herstellen lassen, indem in dieser Zusammensetzung eine Potentialdifferenz erzeugt wird.

Bei der Potentialdifferenz handelt es sich bevorzugt um eine chemische Potentialdifferenz. Diese chemische Potentialdifferenz wird vorzugsweise durch Belichtung oder Elektronenbestrahlung, insbesondere durch holographische oder lithographische Techniken oder über die Maskaligner-Technik, erzeugt. Durch selektive Bestrahlung oder Belichtung der Zusammensetzung kann z. B. an lokalen Stellen gezielt eine Polymerisation und/oder Polykondensation ausgelöst werden, die zu einer chemischen Potentialdifferenz führt, die wiederum zur gerichteten Diffusion der Monomere und zur Ausbildung eines Brechzahlgradienten führt.

Ohne an ein bestimmtes System gebunden zu sein, ließe sich diese Reaktion so erklären, dass durch die lokale Polymerisation und/oder Polykondensation eine Komponente mit einer bestimmten Brechzahl gebildet, bzw. ihre Konzentration dort erhöht, wird, während im Gegenzug die Brechzahl der anderen Bereiche durch die Diffusion der Monomere ebenfalls verändert wird.

In einer starken Vereinfachung kann das System vor dem Anlegen der Potentialdifferenz auch als eine homogene Mischung von zwei Komponenten mit unterschiedlichen Brechzahlen betrachtet werden, wobei darunter auch Vorläuferverbindungen für eine Komponente zu verstehen sind. Durch die gerichtete Diffusion kommt es zu lokalen Veränderungen in den Anteilen der beiden Komponenten. Diese verursacht den beobachteten Brechzahlgradienten.

Daraus folgt, dass, wie vorstehend erwähnt, die Veränderung der Brechzahl immer in Relation zu den Bereichen ohne Polymerisation oder Polykondensation zu sehen ist. Entscheidend ist der daraus resultierende Unterschied in der Brechzahl. Welcher Bereich eine höhere, bzw. niedrigere Brechzahl aufweist, kann beispielsweise durch die Wahl der Monomere und des biologischen Polymers oder anderer Komponenten bestimmt werden.

Ohne an eine bestimmte Theorie gebunden zu sein, kann man vermuten, dass sich durch die Bestrahlung im biologischen Material eine besonders hohe Anzahl an reaktiven Spezies, wie z. B. Radikale, Kationen oder Anionen, bilden, welche die Polymerisation in diesen Bereichen lokal induzieren.

Für die Belichtungsverfahren werden bevorzugt UV-Licht oder Laserlicht eingesetzt. Bei Verwendung eines Lasers als Lichtquelle können über holographische Techniken sowohl periodische Gitterstrukturen als auch Fresnelstrukturen hergestellt werden. Die durch Interferenz auftretenden Intensitätsprofile wirken als Polymerisationssenken. Für die besonders bevorzugte holographische Belichtung können z. B. mittels Zwei-Wellenmischen phasenmodulierte Volumenhologramme als Transmissions- oder Reflexionshologramme hergestellt werden.

Als kohärente Lichtquelle kann z. B. ein Argon-Ionen-Laser dienen.

Nach der Herstellung der Gradientenstruktur können die nicht polymerisierten oder nicht polykondensierten Monomere durch eine nicht-lokale Induktion einer Polymerisation oder Polykondensation, beispielsweise eine nicht intensitätsmodulierte Belichtung, gleichmäßig abreagieren. Da dabei keinerlei gerichtete Diffusion mehr auftritt, kommt es maximal zu einer geringen Abschwächung des bereits erzeugten Brechzahlgradienten. Allerdings kann dadurch die Haltbarkeit der hergestellten Gradientenstrukturen deutlich verbessert werden.

In einer vorteilhaften Weiterbildung der Erfindung absorbiert das mindestens eine biologische Polymer, die zum Schreiben des Hologramms verwendeten Wellenlängen. Mit Vorteil weisen über 50 % der Monomere dieses biologischen Polymers oder der biologischen Polymere aromatische oder heteroaromatische Gruppen auf. Dies können beispielsweise Nukleobasen, wie Adenin, Guanin, Cytosin oder Thymin sein, aber auch aromatische Aminosäuren, wie Phenylalanin oder Tryptophan. Im Falle von Nukleobasen kann es sich bei dem biologischen Polymer um DNA, RNA oder um ein Derivat davon handeln. Bei Derivaten kann es sich um Modifikationen an den Nukleobasen, wie z. B. Alkylierungen, wie 5-Methylcytosin, 4-O-Methylthymin, 7-Alkyl-7-Desazaguanin oder 7-Alkyl-7-Desazaadenin, aber auch Modifikation am Rückgrat des Polymers sein, wie Methylierung der Phosphatgruppen, Verwendung anderer Zuckerbausteine oder Austausch des Zuckerrückgrats durch Peptide wie z. B. Peptid Nucleic Acids (PNA). Das biologische Polymer kann auch aus natürlichen und nicht natürlich vorkommenden Bausteinen bestehen.

Die Größe des biologischen Polymers kann vom verwendeten biologischen Polymer abhängen. Im Falle von DNA und/oder deren Derivate ist eine Größe von über 50 Basen eines Einzelstrangs bis hin zu genomischer DNA möglich, bevorzugt ist einer Größe von über 200 Basen, beispielsweise von 200 bis 10.000 Basen oder 200 bis 1000 Basen. Die DNA und/oder deren Derivate kann als Einzel- oder als Doppelstrang vorliegen. Bevorzugt ist doppelsträngige DNA. Es wird vermutet, dass gerade doppelsträngige DNA besonders vorteilhaft für die Generierung der polymerisationsstartenden Spezies ist. Bei der Größe der DNA ist anzunehmen, dass die DNA in der Zusammensetzung praktisch nicht diffundiert.
Das biologische Polymer kann mit allen dem Fachmann bekannten Techniken gewonnen werden. Dies beinhaltet sowohl Extraktion, wie auch Synthese. Es kann sich um kommerziell erhältliche biologische Polymere handeln.

In einer vorteilhaften Weiterbildung der Erfindung, enthält die Zusammensetzung folgende Komponenten:
(a) 2 bis 98 Gew.-% ein oder mehrerer polymerisierbare oder polykondensierbare Monomere;
(b) 0,001 Gew.-% bis 1 Gew.-% eines oder mehrerer biologischer Polymere;

Zusätzlich kann die Zusammensetzung noch 0 bis 5 Gew.-% eines oder mehrerer Additiv(e) ausgewählt aus Sensibilisierungsmitteln, Netzhilfsmitteln, Haftvermittlern, Verlaufsmitteln, Antioxidationsmitteln, Stabilisatoren, Farbstoffen, photochromen oder thermochromen Verbindungen enthalten.

Mit Vorteil sind alle Komponenten der Zusammensetzung miteinander mischbar. Bevorzugt liegen mindestens alle Komponenten in einer gemeinsamen Phase vor.

Das biologische Polymer liegt in einer in der Zusammensetzung löslichen Form vor. Biologische Polymere sind oft so hydrophil, dass sie sich in der meistens aufgrund des hohen organischen Anteils eher hydrophoben Zusammensetzung nur schlecht oder gar nicht lösen. Für solche Fälle sind dem Fachmann Möglichkeiten bekannt, die Hydrophobie des biologischen Polymers, gerade von DNA und ihren Derivaten zu erhöhen. Dazu zählt neben der Herstellung von Derivaten, wie die Modifikation des biologischen Polymers mit langen Alkylketten, die reversible Anlagerung von grenzflächenaktiven Substanzen, bevorzugt Tenside. Im Falle von stark negativ geladenen biologischen Polymeren, wie DNA und/oder ihren Derivaten, sind kationische Tenside bevorzugt. Beispiele hierfür sind quartäre Ammoniumionen, der Formel NR₄⁺, wobei R gleich oder verschieden sein können und ausgewählt sind aus Alkylresten zwischen einem und 30 Kohlenstoffen, welche auch substituiert sein können. Dies beinhaltet auch Isomere. Die Kohlenstoffketten können auch durch Heteroatome unterbrochen sein oder auch aromatische Reste, wie Phenyl oder Benzyl enthalten. Mit Vorteil ist eine Verbindung der Formel NR'R₃⁺, wobei R einen C₁₋₄-Alkylrest steht, bevorzugt für Methyl oder Ethyl und R' für einen Rest zwischen 4 und 30 Kohlenstoffatomen. Bevorzugt sind Lauryl, Myristyl, Cetyl, Heptadecyl, Behenyl, oder Stearyl, wobei die Alkylreste auch ungesättigt sein können. Beispiele sind Cetyltrimethylammonium, Stearyltrimethylammonium und Cetyltrimethylammonium. Die Substanzen werden bevorzugt als Salze, bevorzugt Chloride und Bromide eingesetzt. Weitere kationische Tenside sind alkylierte Heteroaromaten wie Pyridiniumionen. Beispiele hierfür sind Laurylpyridinium oder Cetylpyridinium. Auch diese Verbindungen werden bevorzugt als Halogenide, wie z.B. Chloride oder Bromide eingesetzt. Es können auch kationische Dendrimere oder Polymere eingesetzt werden, welche z. B. zur Transfektion von Zellen mit DNA eingesetzt werden, z.B. DEAE-Dextran oder kationischen Lipide (z.B. Lipofectin™).

Die Substanzen können auch über eine kovalente Bindung an das biologische Polymer gekoppelt sein, beispielsweise durch Reaktion mit Hydroxyl-, Amino-, Carbonsäure- oder Carboxylgruppen oder anderen reaktiven Gruppen. Dies kann auch Cycloadditionen oder Additionsreaktionen mit in dem Biopolymer enthaltenen Doppelbindungen beinhalten.

Im Falle von DNA und/oder ihren Derivaten können auch Interkalatoren eingesetzt werden. Dies sind Moleküle, welche sich zwischen die Basen der DNA einlagern. Falls diese Interkalatoren mit langen Alkylgruppen versehen sind, können sie auch zu einer erhöhten Hydrophobie beitragen. Beispiele hierfür sind alklyierte polycyclische Aromaten, wie z.B. Pyren oder Naphthalin, welche auch Heteroatome enthalten können. Bekannte Interkalatoren sind auch dem Fachmann bekannte DNA-Farbstoffe, wie Ethidiumbromid, SYBR-Green, Porphyrine, TOTO oder YOYO-1.

Es können auch andere an die Nukleinsäuren bindenden Moleküle, welche in der großen oder kleinen Furche binden, z.B. Oligomere aus Pyrrolen und/oder Imidazolen.

Es können auch Gemische unterschiedlicher grenzflächenaktiver Substanzen eingesetzt werden.

Die Substanzen können direkt zur Zusammensetzung gegeben werden. Bevorzugt ist, dass das biologische Polymer in einem separaten Verfahrensschritt in die eine Form überführt wird, welche sich in der Zusammensetzung löst. Mit Vorteil wird dazu das biologische Polymer beispielsweise aus Wasser durch die Zugabe der grenzflächenaktiven Substanz ausgefällt. Der Gewichtsanteil des einen oder mehreren biologischen Polymers bestimmt sich dann auf das Gewicht des ausgefällten Polymers, d.h. in Kombination mit der grenzflächenaktiven Substanz.

Das Verhältnis der grenzflächenaktiven Substanz zu dem biologischen Polymer hängt vom biologischen Polymer ab. Bevorzugt ist ein Verhältnis von ungefähr 1:1 nach Gewicht.

Das polymerisierbare oder polykondensierbare organische Monomer oder die polymerisierbaren oder polykondensierbaren organischen Monomere können prinzipiell jede dem Fachmann bekannte Spezies umfassen, die zur Polymerisation oder Polykondensation geeignet ist. So können beispielsweise polymerisierbare oder polykondensierbare Monomere, Oligomere oder Prepolymere verwendet werden. Die Monomere können auch mehr als eine polymerisierbare oder polykondensierbare Gruppe enthalten. Bevorzugt werden Monomere, welche transparente Polymere ergeben.

Spezielle Beispiele für polymerisierbare oder polykondensierbare organische Monomere sind (Meth)acrylsäure, (Meth)acrylsäureester, (Meth)acrylnitril, Styrol und Styrol-Derivate, Alkene (z. B. Ethylen, Propylen, Buten, Isobuten), halogenierte Alkene (z. B. Tetrafluorethylen, Chlortrifluorethylen, Vinylchlorid, Vinylfluorid, Vinylidenfluorid, Vinylidenchlorid), Vinylacetat, Vinylpyrrolidon, Vinylcarbazol und Mischungen davon. Auch mehrfach ungesättigte Monomere können vorhanden sein, z. B. Butadien und (Meth)acrylsäureester von Polyolen (z. B. Diolen).

Bevorzugt sind Acrylate oder Methacrylate, insbesondere Methylmethacrylat, ein Diol(meth)acrylat oder ein Diol-di (meth)acrylat, wie z. B. Hexandioldimethacrylat (HDMA), Hexandioldiacrylat, Dodecandioldimethacrylat und Dodecandioldiacrylat. Es können auch Silikonacrylate oder ähnliche Verbindungen, als Monomere verwendet werden. Es können auch Mischungen von Monomeren eingesetzt werden.

Besonders bevorzugt sind auch Acrylate oder Methacrylate mit einer oder mehreren polymerisierbaren Gruppen, sogenannte Vernetzer, welche mit Oligomeren und / oder Polymeren modifiziert sind. Ganz besonders bevorzugt werden Monomere mit einem Molgewicht von bis zu 5000 g/mol, bevorzugt bis zu 1500 g/mol, besonders bevorzugt zwischen 27 g/mol und 600 g/mol. Beispiele für solche Monomere sind Polyethylenglycoldi(meth)acrylate (PEGDMA), Polyethylenglycol(meth)acrylate (PEGMA), Tetramethelenglycoldi(meth)acrylate (TMGDMA), Bisphenyl-A-di(meth)acrylate (BPADMA) oder Tetraethylenglycoldi(meth)acrylate (TEGDMA).

Unter (Meth)acrylaten wird erfindungsgemäß sowohl das jeweilige Acrylat als auch das jeweilige Methylacrylat verstanden, dies gilt analog für (Meth)acrylsäure oder (Meth)acrylsäureester.

Die Zusammensetzung kann noch zusätzlich für optische Systeme übliche Additive enthalten. Beispiele sind Weichmacher, Sensibilisierungsmittel, Netzhilfsmittel, Haftvermittler, Verlaufsmittel, Antioxidationsmittel, Stabilisatoren, Farbstoffe und photochrome oder thermochrome Verbindungen.

Wie bereits ausgeführt scheint das biologische Polymer selbst die zur lokalen Polymerisation nötigen Spezies zu erzeugen. Ein Vorteil des erfindungsgemäßen Systems ist daher auch, dass es nicht auf die Zugabe von thermischen oder photochemischen Vernetzungsinitiatoren angewiesen ist. Dennoch könnte es vorteilhaft sein, beispielsweise Vernetzungsinitiatoren, welche die Aushärtung der Zusammensetzung nach Herstellung des Brechzahlgradienten beschleunigen. Als Katalysatoren/Initiatoren bzw. Vernetzungsinitiator dafür kommen alle geläufigen und dem Fachmann bekannten Starter/Startsysteme in Frage, einschließlich radikalischer Photostarter, radikalischer Thermostarter, kationischer Photostarter, kationischer Thermostarter und beliebiger Kombinationen derselben.

Konkrete Beispiele für einsetzbare radikalische Photostarter sind Irgacure ® 184 (1-Hydroxycyclohexylphenylketon),Irgacure ® 500 (1-Hydroxycyclohexylphenylketon, Benzophenon) und andere von der Firma Ciba-Geigy erhältliche Photoinitiatoren vom Irgacure®-Typ, Darocure 1173, 1116, 1398, 1174 und 1020 (Fa. Merck), Benzophenon, 2-Chlorthioxanthon,2-Methylthioxanthon,2-Iso-propylthioxanthon, Benzoin, 4,4'-Dimethoxybenzoin, Benzoinethylether, Benzoinisopropylether, Benzildimethylketal, 1,1,1-Trichloracetophenon, Diethoxyacetophenon und Dibenzosuberon.

Beispiele für radikalische Thermostarter sind bevorzugt organische Peroxide in Form von Diacylperoxiden, Peroxydicarbonaten, Alkylperestern, Alkylperoxiden, Dialkylperoxiden, Perketalen, Ketonperoxiden und Alkylhydroperoxiden sowie Azo-Verbindungen. Als konkrete Beispiele wären hier insbesondere Dibenzoylperoxid, tert-Butylperbenzoat und Azobisisoäbutyronitril zu nennen. Ein Beispiel für einen kationischen Photostarter ist Cyracure® UVI-6974, während ein bevorzugter kationischer Thermostarter 1-Methylimidazol ist.

Die Polykondensation induzierenden Katalysatoren sind z. B. Brönsted-Säuren und -Basen, wie Mineralsäuren oder tertiäre Amine, für die anionische Polykondensation und Lewis-Säuren, wie Metallalkoholate (z. B. Aluminiumalkoholate im Falle von Epoxysilanen), für die kationische Polykondensation. Bei Beteiligung von Epoxidgruppen ist der Zusatz von Ringöffnungskatalysatoren wie beispielsweise N-Alkylimidazolen von besonderem Vorteil.

Wie bereits ausgeführt, ist der Einsatz solcher Katalysatoren oder Sensibilisatoren nicht zwingend und nicht bevorzugt.

Gegebenenfalls kann die Zusammensetzung noch eines oder mehrere Lösungsmittel enthalten, bevorzugt organische Lösungsmittel, beispielsweise Alkohole, wie Ethanol, Isopropanol oder Butanol, Ketone wie Aceton, Ester wie Ethylacetat, Ether wie Tetrahydrofuran und aliphatische, aromatische und halogenierte Kohlenwasserstoffe, wie Hexan, Benzol, Toluol und Chloroform.

Der Lösungsmittelanteil der Zusammensetzung kann vor oder nach der Herstellung des Brechzahlgradienten variiert werden, beispielsweise durch Erwärmen. Bevorzugt ist ein Lösungsmittelanteil von 0 bis 70 Gew.-%. Falls die Anteile der anderen Bestandteile, z.B. des einen oder der mehreren polymerisierbaren und/oder polykondensierbaren Monomeren und des einen oder mehreren biologischen Polymers, nicht 100 % ausmachen, ist es bevorzugt den fehlenden Anteil durch mindestens ein Lösungsmittel zu ergänzen.

In einer vorteilhaften Weiterbildung kann die Zusammensetzung noch ein Matrixmaterial enthalten. Dies ist insbesondere von Vorteil, wenn Monomere verwendet werden, welche nicht mit einem Oligomer oder Polymer modifiziert sind. Die zugegebene Matrix kann sowohl die Entstehung des Brechzahlgradienten, indem beispielsweise die Diffusion der Monomere beeinflusst wird, als auch, wie schon ausgeführt, den entstehenden Brechzahlgradienten beeinflussen. Darüberhinaus kann die Matrix zur Stabilisierung des Brechzahlgradienten beitragen. Bevorzugt werden Matrixmaterialien, die in der Zusammensetzung löslich sind.

Die Menge an Matrixmaterial ist nicht kritisch und kann zwischen 0,1 bis 98 Gew.-% liegen.

Das Matrixmaterial kann ein polymerisierbares oder polykondensierbares organisches Monomer, Oligomer und / oder Prepolymer, ein organisches Polymer und / oder ein Kondensat aus einer oder mehreren hydrolysierbaren, gegebenenfalls organisch modifizierten anorganischen Verbindungen umfassen. Das Matrixmaterial umfasst bevorzugt mindestens ein organisches Polymer.

Bei den organischen Polymeren, die im Matrixmaterial enthalten sein können, kann es sich um beliebige bekannte Kunststoffe handeln. Bevorzugt sind Polymere, die sich in den oben genannten Lösungsmitteln oder Gemischen davon lösen, z.B. Polyacrylsäure, Polymethacrylsäure, Polyacrylate, Polymethacrylate, Polyethylenglykole, Polyolefine, Polystyrol, Polyamide, Polyimide, Polyvinyl-Verbindungen wie Polyvinylchlorid, Polyvinylalkohol, Polyvinylbutyral, Polyvinylacetat, Polyvinylpyrrolidon, Paravinylguajacol und entsprechende Copolymere, z.B. Poly-(ethylenvinylacetat), Polyester, z.B. Polyethylenterephthalat oder Polydiallylphthalat, Polyarylate, Polycarbonate, Polyether, z.B. Polyoxymethylen, Polyethylenoxid und Polyphenylenoxid, Polyetherketone, Polysulfone, Polyepoxide, Fluorpolymere, z. B. Polytetrafluorethylen, und Organopolysiloxane. Es können auch Silikone oder ähnliche Polymere eingesetzt werden. Auch Copolymere aus unterschiedlichen Monomeren sind geeignet. Vorzugsweise handelt es sich um transparente Polymere. Bevorzugt sind dabei Polymere mit einem mittleren Molekulargewicht von 8000 bis 43000 g/mol.

In einer vorteilhaften Weiterbildung kann die Zusammensetzung auch die eine, vorzugsweise transparente, härtbare Matrix enthalten.

Unter Härtung versteht man in diesem Fall Polymerisationen, Polykondensationen und / oder Polyadditionen, welche zu einer Verfestigung der Matrix führen.

Die Menge an härtbarer Matrix ist nicht kritisch und kann zwischen 0,1 bis 98 Gew.-% liegen. Dies betrifft insbesondere in vorteilhafter Weise den Aspekt, wenn die Stabilisierung des Brechzahlgradienten gefordert ist. Die härtbare Matrix beeinflusst die Entstehung des Brechzahlgradienten, indem beispielsweise die Diffusion der Monomere verändert wird. Darüber hinaus kann auch, wie schon ausgeführt, der Brechzahlunterschied zwischen Matrix und den polymerisierten oder polykondensierten Monomeren zur Ausbildung des Brechzahlgradienten genutzt werden. Die Härtung der Matrix kann sowohl vor, während, als auch nach der Erzeugung der Potentialdifferenz durchgeführt werden, bevorzugt vor der Erzeugung der Potentialdifferenz.

Bevorzugt werden Matrixmaterialien, bzw. Vorläufer der härtbaren Matrix verwendet, die in der Zusammensetzung löslich sind.

Bei der härtbaren Matrix kann es sich beispielsweise um die üblichen organischen Bindemittelsysteme für Lacke und Harze handeln. Die Härtung der Matrix kann physikalisch oder bevorzugt chemisch erfolgen. Es kann sich um oxydativ härtende, kalthärtende oder um thermisch oder durch Bestrahlung härtende Harze handeln. Es kann sich um Ein- oder Zweikomponentenlacke handeln. Bevorzugt handelt es sich um chemisch härtende oder vernetzbare Bindemittelsysteme. Solche härtbaren Bindemittelsysteme sind dem Fachmann geläufig.

Bei den einsetzbaren Bindemittelsystemen oder Lacken bzw. den dafür verwendeten Polymeren oder Oligomeren oder Vorstufen davon handelt es sich z. B. um die üblichen, aus dem Stand der Technik bekannten Bindemittelsysteme. Insbesondere handelt es sich um organische Polymere, Oligomere oder Vorstufen davon. Unter den Vorstufen der Polymere oder Oligomere werden die Monomere oder daraus gebildete niedermolekulare Polymerisations-, Kondensations- oder Additionsprodukte verstanden, von denen die Polymere oder Oligomere abgeleitet sind.

Beispiele für Bindemittelsysteme oder Lacke bzw. die dafür verwendeten organische Polymere oder Oligomere sind EpoxidharzLacke, wie Bisphenol-A-Harze, Bisphenol-F-Harze, aliphatische und heterocyclische Epoxidharze oder thermoplastische Epoxidlackharze; Öllacke, die Öle, wie z.B. Leinöl, Holzöl oder Sojaöl enthalten, die gegebenenfalls mit Polybutadienölen modifiziert sind; Nitrocellulose-Lacke, die Nitrocellulosen enthalten; Lacke aus Celluloseester organischer Säuren, wie Ester der Cellulose mit Essigsäure oder Buttersäure oder die Anhydride davon, wobei z.B. Celluloseacetobutyrate auch in Polyurethanlacken Verwendung finden; Chlorkautschuk-Lacke, die z.B. chloriertes Polyisopren, Polypropylen oder Polyethylen enthalten; Lacke aus Polyvinylverbindungen bzw. Polyvinylharzen, wie Polyolefine, z.B. Polyethylen, EthylenVinylacetat-Copolymere und Ethylen-Maleinsäure-(anhydrid)-Copolymere, PVC, Polyvinylidenchlorid, Polyvinylalkohol, Polyvinylacetale, z.B. Polyvinylbutyral, Polyvinylether, z.B. Methyl- oder Ethylether, Polyvinylester, z.B. Polyvinylacetat (PVA) und Polyethylenterephthalat, Polyvinylpyrrolidon, Polystyrol, Styrol-Acrylnitril-Copolymere (SAN), Acryinitril-Butadien-Styrol-Copolymere (ABS), Styrol-Maleinsäureester-Copolymere, Styrol-Butadien-Copolymere und Styrol-Maleinsäureanhydrid-Copolymere; Lacke auf Basis von Acrylharzen, wie Polyacrylsäure, Polymethacrylsäure, Polyacryl-amid, Acrylester oder Methacrylester, z.B. Polymethyl(meth)acrylat; Alkydharze, die zweibasische Säuren oder Anhydride, wie Phthalsäure und Phtalsäureanhydrid, und Polyole oder Kondensationsproduke davon enthalten, die öl- oder fettsäuremodifiziert sind; gesättigte Polyesterharz-Lacke, die gesättigte Polyester aus gesättigten Monomeren mit zwei oder mehr funktionellen Gruppen (OH- und / oder COOH-Gruppen) enthalten; PolyurethanLacke, die häufig als Zweikomponentensysteme verwendet werden, die blockierte oder unblockierte Polyisocyanate und Polyhydroxylverbindungen enthalten; Siliconharz-Lacke; Harnstoff-, Melamin- und Phenolharz-Lacke; sowie Polyarylate, Polyamide, Polyether, Polyimide und Polycarbonate. Es können auch Kombinationen dieser Lacke bzw. dieser Polymere verwendet werden. Es können immer auch die Vorstufen, wie z.B. die Monomere der genannten Polymere oder Oligomere, eingesetzt werden.

Bevorzugte Bindemittelsysteme sind Polyurethanharz-Lacke und Polyepoxidharz-Lacke. Das Bindemittelsystem umfasst auch die gegebenenfalls eingesetzten Härter oder Vernetzer.

Bevorzugt handelt es sich um ein Bindemittelsystem, welches nicht mit den eingesetzten Monomeren reagiert und somit unabhängig von Polymerisation des Photopolymers reagiert.

Bevorzugt eingesetzte organische Polymere oder Oligomere oder Vorstufen davon, wie Monomere, sind Polyepoxide, Polyole, unblockierte oder insbesondere blockierte Polyisocyanate, Polyester, Polyamine, Polycarbonsäuren oder Polycarbonsäureanhydride, die jeweils zwei oder mehr funktionelle Gruppen enthalten.

Hier bezieht sich der Ausdruck "Poly" auf die funktionelle Gruppe und nicht auf den Polymerisationsgrad. Dementsprechend besitzen die Polyole zwei oder mehr Hydroxygruppen und es kann sich um ein Monomer, Oligomer oder Polymer (z.B. ein Polyurethan) handeln. Konkrete Komponenten werden im Folgenden an bevorzugten Bindemittelsystemen beispielhaft veranschaulicht.

Es können dem Fachmann bekannte Bindemittelsystem auf Epoxidbasis eingesetzt werden. Beispiele für Polyepoxide sind Bisphenol-A-Harze (z.B. Kondensationsprodukte aus Bisphenol A und Epichlorhydrin), Bisphenol-F-Harze (z.B. Kondensationsprodukte aus Bisphenol F und Epichlorhydrin), aliphatische Epoxidharze (z.B. niedrig viskose Glycidylether), cycloaliphatische Epoxidharze und heterocyclische Epoxidharze (z.B. Triglycidylisocyanurat) oder thermoplastische Epoxidharz-Lacke. Solche Systeme beinhalten auch die Verwendung von "expanding monomers" (z. B. Spiroorthocarbonate oder Spiroorthoester), welche auch erst in situ gebildet werden können. Häufig werden Polyepoxidharze für die Filmbildung mit Härtern versetzt, um eine Vernetzung zu erzielen. Als Härter kommen organische oder anorganische Verbindungen mit reaktionsfähigem Wasserstoff in Betracht, die mit Epoxid- oder Hydroxylgruppen reagieren können. Beispiele für eingesetzte Härter sind Polyamine (z. B. Diamine, wie Ethylendiamin, Cyclohexaminderivate), Polyaminoamidharze, Polyisocyanate, hydroxylhaltige Kunstharze, wie Harnstoff-, Melamin- und Phenolharze, Fettsäuren und organische Säuren mit reaktionsfähigen Doppelbindungen, wie Acrylsäure oder Methacrylsäure. Bei Einsatz der letztgenannten Härter kann die Vernetzung auch durch Elektronenstrahlung erfolgen.

Polyisocyanate werden z.B. für Polyurethanharze verwendet. Das Polyisocyanat kann zwei oder mehr Isocyanatgruppen aufweisen.

Es kann z.B. aliphatisch, alicyclisch, aromatisch oder heterocyclisch, monocyclisch oder polycyclisch sein.

Es können übliche Polyisocyanate verwendet werden, z.B. monomere Polyisocyanate, Polyisocyanat-Addukte, sogenannte modifizierte Polyisocyanate oder Mischungen davon. Diese sind dem Fachmann bekannt und im Handel erhältlich.

Bei den Polyisocyanat-Addukten handelt es sich z.B. um solche, die üblicherweise als Härter für zweikomponentige Urethanlacke Verwendung finden.

Beispiele für geeignete Polyisocyanate sind die aus der Polyurethanchemie bekannten Diisocyanate, wie z.B. 1,3-Diisocyanatobenzol, 2,4 und 2,6-Toluylendiisocyanat (TDI), 1, 6-Hexamethylendiisocyanat (HMDI), 4,4'- und 2,4-Diphenylmethandiisocyanat (MDI), Naphthylendiisocyanat, Xylylendiisocyanat, Isophorondiisocyanat, Paraphenyldiisocyanat, Dicyclohexylmethandiisocyanat, Cyclohexyidiisocyanat, Polymethylpolyphenylisocyanat, 1,6-Dodecamethylendiisocyanat, 1,4-Bis (isocyanatocyclohexyl) methan, Pentamethylendiisocyanat, Trimethylendiisocyanat, Triphenylmethandiisocyanat, sowie die aus diesen Diisocyanaten abgeleiteten höhermolekulare Polyisocyanate z.B. auf Isocyanurat-, Uretdion-, Allophanat- und Biuretbasis.

Die Isocyanate sind z.B. unter den Handelsbezeichnungen Desmodur und Baymidur (von Bayer), CARADATE (von Shell), TEDIMONX (von Enichem) und LUPRANAT (von BASF) erhältlich. Beispiele für monomere Polyisocyanate mit mehr als zwei Isocyanatgruppen sind z. B. 4-Isocyanatomethyl-1,8-octandiisocyanat und aromatische Polyisocyanate wie 4,4',4"-Triphenylmethantriisocyanat oder Polyphenylpolymethylenpolyisocyanate.

Das Polyisocyanat kann in blockierter Form verwendet werden, um zu verhindern, dass eine unkontrolliert schnelle Reaktion einsetzt, und erst nach Entblockierung, z.B. durch Erwärmen, reaktiv werden. Die Blockierung von Isocyanaten ist ein dem Fachmann bekanntes Verfahren zur reversiblen Herabsetzung der Reaktivität von Isocyanaten. Zur Blockierung der Isocyanate kommen alle gängigen Blockierungsmittel in Betracht, wie z.B. Acetonoxim, Cyclohexanonoxim, Methylethylketoxim, Acetophenonoxim, Benzophenonoxim, 3,5-Dimethylpyrazol, 1,2,4-Triazol, Malonsäureethylester, Acetessigsäureethylester, β-Caprolactam, Phenol oder Ethanol.

Als Polyolkomponente können reine Di-, Tri- oder Polyalkohole, wie z.B. Ethylenglycol, Trimethylolpropan, oder partiell verseifte Fettsäureglyceride verwendet werden. Diese werden aber gewöhnlich nur als Ausgangsbasis für höhermolekulare Polyhydroxylverbindungen verwendet. Hierbei kann es sich z.B. um mit Dicarbonsäuren entstehende, mehr oder weniger verzweigte Polyesterpolyole (Desmophen ®- Typen) oder durch Anlagerung von Epoxiden entstehende Polyetherpolyole (Desmophen ® U-Typen) handeln. Andere Beispiele sind hydroxyfunktionelle Acrylharze (Desmophen A-Typen).

Aus den Polyisocyanaten und den Polyolen können Polyurethanharz-Lacke gebildet werden. Natürlich kann es vor allem bei unblockierten Polyisocyanaten erforderlich sein, die Komponenten erst kurz vor Gebrauch miteinander zu mischen. Polyisocyanate können auch mit Verbindungen mit anderen funktionellen Gruppen, die aktiven Wasserstoff enthalten, umgesetzt werden. Beispiele für diese Gruppen sind Thiolgruppen (-SH), primäre oder sekundäre Aminogruppen (-NHR', worin R' z.B. H, Alkyl, Cycloalkyl, Aryl und entsprechende Aralkyl- und Alkarylgruppen sein kann) oder Carboxylgruppen (-COOH). Als Reaktionsprodukte bilden sich bei der Umsetzung mit Isocyanaten Urethane (bei Hydroxyl und Carboxyl), Thiourethane (bei Thiol) oder Harnstoffe (bei Amin).

Polyamide sind Kondensationsprodukte von Diaminen und Dicarbonsäuren oder deren Derivaten, wobei aliphatische und/oder aromatische Verbindungen eingesetzt werden können. Polyamide mit aromatischen Einheiten sind insbesondere bezüglich der Temperaturstabilität interessant. Auch Polyimide, z. B. Polykondensate aus aromatischen Diaminen, wie Benzidin, 4,4-Diaminodiphenylether oder 4,4'-Bis(3-amino-phenoxy)diphenylsulfon, und aromatischen Tetracarbonsäuren oder deren Derivaten, wie 4,4'-Benzophenontetracarbonsäuredianhydrid oder Pyromellitsäuredianhydrid, und Polybenzimidazole, die Kondensationsprodukte aus aromatischen Tetraminen und Dicarbonsäuren oder deren Derivaten darstellen, zeichnen sich durch hohe Wärmebeständigkeit aus. In der erfindungsgemäßen Zusammensetzung können für die genannten Kunststoffe die entsprechenden Monomere oder niedermolekulare Kondensationsprodukte eingesetzt werden.

Die vorstehend genannten Bindemittelsysteme eignen sich insbesondere für Beschichtungszusammensetzungen. Sie sind aber auch als Bindemittelsysteme für Formmassen zur Herstellung von Formkörpern geeignet, wobei Formkörper auch Folien beinhaltet. Epoxidharze oder Polyurethanharze sind z.B. auch zur Herstellung von Formkörpern gut geeignet.

Gerade bei der Verwendung von Epoxid-Harzen ist praktisch keine Schrumpfung durch die Polymerisation des Monomers mehr zu beobachten. Bei der Verwendung von selbsthärtenden Harzen ist auch keine Belichtung zur Härtung der Matrix nötig.

Die Härtung kann aber auch mit der Abreaktion von bei der Bildung der Gradientenstruktur nicht umgesetzter Monomere verbunden werden.

In einer vorteilhaften Weiterbildung kann als härtbares Matrixmaterial auch ein organisch modifiziertes anorganisches Kondensat aus polymerisierbaren oder polykondensierbaren Monomeren und / oder hydrolysierbaren Silanen, welche auch polymerisierbare und / oder polykondensierbare Gruppen aufweisen können, verwendet werden. Solche Zusammensetzungen sind bspw. aus WO 03/058292 bekannt, auf die hiermit explizit Bezug genommen wird.

Dies können z. B. hydrolysierbare und kondensierbare Verbindungen von Si, Al, B, Pb, Sn, Ti, Zr, V und Zn, insbesondere solche von Si, Al, Ti und Zr oder Mischungen davon, sein.

Besonders bevorzugte Matrixmaterialien sind Polykondensate aus einem oder mehreren hydrolysierbaren und kondensierbaren Silanen, wobei gegebenenfalls mindestens ein Silan einen nicht hydrolysierbaren Rest, der polymerisierbar oder polykondensierbar ist, aufweist. Besonders bevorzugt werden ein oder mehrere Silane mit den folgenden allgemeinen Formeln (I) und/oder (II) verwendet:

SiX₄ (I)

worin die Reste X gleich oder verschieden sind und hydrolysierbare Gruppen oder Hydroxygruppen bedeuten,

RₐSiX₍₄₋ₐ₎ (II)

worin R gleich oder verschieden ist und einen nicht hydrolysierbaren Rest darstellt, der gegebenenfalls eine polymerisierbare oder polykondensierbare Gruppe aufweist, X die vorstehende Bedeutung hat und a den Wert 1,2 oder 3, vorzugsweise 1 oder 2, hat.

In den obigen Formeln sind die hydrolysierbaren Gruppen X beispielsweise Wasserstoff oder Halogen (F, Cl, Br oder I), Alkoxy (vorzugsweise C₁₋₆-Alkoxy, wie z. B. Methoxy, Ethoxy, n-Propoxy, i-Propoxy und Butoxy), Aryloxy (vorzugsweise C₆₋₁₀-Aryloxy, wie z. B. Phenoxy), Acyloxy (vorzugsweise C₁₋₆-Acyloxy, wie z. B. Acetoxy oder Propionyloxy), Alkylcarbonyl (vorzugsweise C₂₋₇-Alkylcarbonyl, wie z. B. Acetyl), Amino, Monoalkylamino oder Dialkylamino mit vorzugsweise 1 bis 12, insbesondere 1 bis 6 Kohlenstoffatomen in der bzw. den Alkylgruppe (n).

Der nicht hydrolysierbare Rest R ist beispielsweise Alkyl (vorzugsweise C₁₋₆-Alkyl, wie z. B. Methyl, Ethyl, n-Propyl, Isopropyl, n-Butyl, s-Butyl und t-Butyl, Pentyl, Hexyl oder Cyclohexyl), Alkenyl (vorzugsweise C₂₋₆-Alkenyl, wie z. B. Vinyl, 1-Propenyl, 2-Propenyl und Butenyl), Alkinyl (vorzugsweise C₂₋₆-Alkinyl, wie z. B. Acetylenyl und Propargyl) und Aryl (vorzugsweise C₆₋₁₀-Aryl, wie z. B. Phenyl und Naphthyl). Die genannten Reste R und X können gegebenenfalls einen oder mehrere übliche Substituenten, wie z. B. Halogen, Ether-, Phosphorsäure-, Sulfonsäure-, Cyano-, Amid-, Mercapto-, Thioether-oder Alkoxygruppen, als funktionelle Gruppen aufweisen.

Der Rest R kann eine polymerisierbare oder polykondensierbare Gruppe enthalten. Hierzu gehören auch die obigen Alkenyl-und Alkinylgruppen. Konkrete Beispiele für die polymerisierbaren oder polykondensierbaren Gruppen des Restes R sind Epoxy-, Hydroxy-, Amino-, Monoalkylamino-, Dialkylamino-, Carboxy-, Allyl-, Vinyl-, Acryl-, Acyloxy-, Methacryl-, Methacryloxy-, Cyano-, Aldehyd-und Alkylcarbonylgruppen. Diese Gruppen sind vorzugsweise über Alkylen-, Alkenylen-oder Arylen-Brückengruppen, die durch Sauerstoff-oder Schwefelatome oder-NH-Gruppen unterbrochen sein können, an das Siliciumatom gebunden. Die genannten Brückengruppen leiten sich zum Beispiel von den oben genannten Alkyl-, Alkenyl-oder Arylresten ab. Die Brückengruppen der Reste R enthalten vorzugsweise 1 bis 18, insbesondere 1 bis 8 Kohlenstoffatome.

Besonders bevorzugte hydrolysierbare Silane der allgemeinen Formel (I) sind Tetraalkoxysilane, wie Tetraethoxysilan (TEOS) und Tetramethoxysilan. Besonders bevorzugte Organosilane der allgemeinen Formel (II) sind Epoxysilane wie 3-Glycidyloxypropyltrimethoxysilan (GPTS) und über reaktive polymerisierbare Doppelbindungen verfügende Silane, wie Vinyltriethoxysilan, Methacryloxypropyltrimethoxysilan und Acryloxypropyltrimethoxysilan. Weitere bevorzugt verwendete Silane sind Dimethyldimethoxysilan, Dimethyldiethoxysilan oder Methyltriethoxysilan. Bevorzugt werden Kombinationen von Silanen mit einem nicht hydrolysierbaren Rest mit polymerisierbarer oder polykondensierbarer Gruppe und einem weiteren Silan, das keine polymerisierbare oder polykondensierbare Gruppe aufweist, eingesetzt.

Es können natürlich auch ein oder mehrere Silane verwendet werden, die 1 oder 2 nicht hydrolysierbare Reste ohne polymerisierbare oder polykondensierbare Gruppen und 1 oder 2 nicht hydrolysierbare Reste mit polymerisierbaren oder polykondensierbaren Gruppen aufweisen, wobei insgesamt nicht mehr als 3 nicht hydrolysierbare Reste am Si gebunden sind.

Es wird bevorzugt mindestens ein Silan eingesetzt, das einen nicht hydrolysierbaren Rest mit einer polymerisierbaren oder polykondensierbaren Gruppe aufweist. Über diese Gruppen kann, gegebenenfalls zusammen mit ebenfalls eingesetzten polymerisierbaren oder polykondensierbaren organischen Monomeren, Oligomeren und/oder Prepolymeren, eine Polymerisation oder Polykondensation bzw. eine Vernetzung des Matrixmaterials erfolgen.

Zur Unterscheidung vom anorganischen Kondensationsgrad, der sich durch Hydrolyse und Kondensation der hydrolysierbaren anorganischen Verbindungen, z. B. unter Bildung von Si-O-Si-Brücken, ergibt, wird das Ausmaß der Verknüpfung über die polymerisierbaren oder polykondensierbaren Gruppen der nicht hydrolysierbaren Reste der hydrolysierbaren Verbindungen im folgenden als organischer Polymerisations-oder Polykondensationsgrad bezeichnet.

Die Hydrolyse und Polykondensation der obigen Verbindungen werden auf herkömmliche Art und Weise durchgeführt, gegebenenfalls in Gegenwart eines Lösungsmittels und eines sauren oder basischen Kondensationskatalysators wie HCl, HNO₃ oder NH₃. So können Hydrolyse und Polykondensation beispielsweise unter den (allgemein bekannten) Bedingungen des Sol-Gel-Prozesses erfolgen.

Zur Herstellung des festen oder gelartigen, aber noch härtbaren Matrixmaterials wird bevorzugt mit einer unterstöchiometrischen Menge Wasser, z. B. mit der 0,3 bis 0,9-fachen stöchiometrischen Menge, hydrolysiert. Die Kondensation erfolgt bevorzugt bei einer Temperatur von 5 bis 40 °C.

Das feste oder gelartige, aber noch härtbare Matrixmaterial enthält vorzugsweise ein Kondensat mit einem anorganischen Kondensationsgrad von 33 bis 100 % und einem organischen Polymerisations-oder Polykondensationsgrad von 0 bis 95% auf. Ein anorganischer Kondensationsgrad von 33% bedeutet beispielsweise, dass im Durchschnitt einer von drei hydrolysierbaren Resten unter Bildung einer anorganischen Brücke wie Si-O-Si kondensiert ist. Der organische Polymersations- oder Polykondensationsgrad gibt an, wie viele polymerisierbare oder polykondensierbare Gruppen in den nicht hydrolysierbaren Resten über eine Polymerisations-oder Polykondensationsreaktion umgesetzt wurden, ein organischer Polymerisations- oder Polykondensationsgrad von 95% bedeutet z. B., dass 95% aller polymerisierbaren oder polykondensierbaren Gruppen in den nicht hydrolysierbaren Resten polymerisiert oder polykondensiert sind.

Sofern die polymerisierbare oder polykondensierbare Gruppe eine olefinische Doppelbindung enthält, kann der Umsatz über IR-Spektroskopie beobachtet werden. Eine Polykondensation kann z. B. bei Epoxidgruppen durch saure oder basische Katalyse bewirkt werden. Gruppen mit olefinischen Doppelbindungen können z. B. mittels UV-Belichtung polymerisiert werden.

Zusätzlich ist die erfindungsgemäße Ausbildung von Gradientenstrukturen auch auf Kompositmaterialien übertragbar. Dazu können der Erfindung nanoskalige Teilchen zugegeben werden, welche gegebenenfalls oberflächenmodifiziert sein können. Abhängig vom Material der nanoskaligen Teilchen können diese zu einer Erhöhung oder einer Erniedrigung der Brechzahl führen. Die Nanopartikel können dabei ebenfalls mit polymerisierbare oder polykondensierbare Oberflächengruppen aufweisen. Das erfindungsgemäße Verfahren führt auch für diese Kompositmaterialien zu deutlichen Verbesserungen. Die Herstellung und Oberflächenmodifizierung der nanoskaligen Teilchen sind aus WO 03/058292 bekannt, auf die hiermit explizit Bezug genommen wird. Abhängig von der Art der Ausführung können die nanoskaligen Teilchen dabei als diffundierende Komponente, d.h. analog zu den Monomeren, oder auch als Bestandteil der Matrix verwendet werden.

Die bevorzugt einsetzbaren nanoskaligen Teilchen weisen vorzugsweise einen Durchmesser von nicht mehr als 100 nm, insbesondere nicht mehr als 50 nm und besonders bevorzugt nicht mehr als 20 nm auf. Hinsichtlich der Untergrenze gibt es keine besonderen Beschränkungen, wenngleich diese Untergrenze aus praktischen Gründen in der Regel bei 0,5 nm, insbesondere 1 nm und häufiger 4 nm liegt. Der Brechungsindex hängt von der Art der Teilchen ab und ist dem Fachmann bekannt.

Die nanoskaligen Teilchen sind insbesondere anorganische Teilchen und umfassen zum Beispiel Oxide, wie ZnO, CdO, SiO₂, TiO₂, ZrO₂, CeO₂, SnO₂, Al₂O₃, In₂O₃, La₂O₃, Fe₂O₃, Ta₂O₅, Cu₂O, V₂O₅, MoO₃ oder WO₃; Chalkogenide, z. B. Sulfide, wie CdS, ZnS, PbS oder Ag₂S; Selenide, wie GaSe, CdSe oder ZnSe ; und Telluride, wie ZnTe oder CdTe; Halogenide, wie AgCl, AgBr, AgI, CuCl, CuBr, CdI₂ oder PbI₂; Carbide, wie CdC₂ oder SiC ; Arsenide, wie AlAs, GaAs oder GeAs; Antimonide wie InSb ; Nitride, wie BN, AlN, Si₃N₄ oder Ti₃N₄; Phosphide, wie GaP, InP, Zn₃P₂ oder Cd₃P₂; Phosphate; Silicate; Zirkonate; Aluminate; Stannate; und entsprechende Mischoxide, z. B. solche mit Perowskitstruktur, wie BaTiO₃ oder PbTiO₃.

Die Herstellung dieser nanoskaligen Teilchen kann auf übliche Weise erfolgen, z. B. durch Flammpyrolyse, Plasmaverfahren, Kolloidtechniken, Sol-Gel-Prozesse, kontrollierte Keim-und Wachstumsprozesse, MOCVD-Verfahren und Emulsionsverfahren. Die Herstellung der nanoskaligen Teilchen kann auch in situ in Anwesenheit des noch flüssigen Matrixmaterials (oder Teilen davon) erfolgen, beispielsweise unter Verwendung von Sol-Gel-Prozessen. Diese Verfahren sind in der Literatur ausführlich beschrieben.

Bevorzugt werden oberflächenmodifizierte nanoskalige Teilchen verwendet. Auch die gegebenenfalls vorgenommene Modifizierung der Oberfläche der nanoskaligen Teilchen mit geeigneten funktionellen Gruppen (z. B. polymerisierbaren oder hydrophoben Gruppen) ist z. B. aus der DE-A-19719948 oder DE-A- 19746885 und EP-B-636111 bekannt.

Die Herstellung von oberflächenmodifizierten nanoskaligen Teilchen kann prinzipiell auf zwei verschiedenen Wegen durchgeführt werden, nämlich zum einen durch Oberflächenmodifizierung von bereits hergestellten nanoskaligen anorganischen Feststoffteilchen und zum anderen durch Herstellung dieser anorganischen nanoskaligen Feststoffteilchen unter Verwendung von einer oder mehreren Verbindungen, die für die Oberflächenmodifizierung geeignet sind. Für die Oberflächenmodifizierung direkt bei Herstellung der Teilchen eignen sich auch alle nachstehend genannten Verbindungen für eine anschließende Oberflächenmodifizierung.

Wird eine Oberflächenmodifizierung bereits hergestellter nanoskaliger Teilchen durchgeführt, eignen sich zu diesem Zweck alle Verbindungen (bevorzugt mit einem Molekulargewicht unter 300 und insbesondere unter 200), die über eine oder mehrere Gruppen verfügen, die mit auf der Oberfläche der nanoskaligen Feststoffteilchen vorhandenen (funktionellen) Gruppen (wie beispielsweise OH-Gruppen im Falle von Oxiden) reagieren oder zumindest wechselwirken können.

Bevorzugt wird die Ausbildung von kovalenten und/oder koordinativen Bindungen. Konkrete Beispiele für zur Oberflächenmodifizierung der nanoskaligen anorganischen Feststoffteilchen heranziehbare organische Verbindungen sind beispielsweise gesättigte oder ungesättigte Carbonsäuren, wie (Meth) acrylsäure, β-Dicarbonyl-Verbindungen (z. B. gesättigte oder ungesättigte β-Diketone oder β-Carbonylcarbonsäuren), Alkohole, Amine, Epoxide und dergleichen.

Besonders bevorzugt wird die Oberflächenmodifizierung mit hydrolytisch kondensierbaren Silanen mit mindestens (und vorzugsweise) einem nicht hydrolysierbaren Rest durchgeführt. Hierfür eignen sich z. B. die vorstehend genannten hydrolysierbaren Silane der Formel (II), bevorzugt solche mit einer (Meth) acrylgruppe. Besonders bevorzugt ist der Einsatz von oberflächenmodifizierten Teilchen, die eine polymerisierbare oder polykondensierbare Gruppe an der Oberfläche aufweisen. Besonders bevorzugt handelt es sich dabei um (Meth)acryl-, Allyl-, Vinyl-, Epoxy-, Hydroxy-, Carboxy- oder Aminogruppen.

Das Nanokompositmaterial kann auch für optische Systeme übliche Additive enthalten. Beispiele sind Weichmacher, ggf. thermische oder photochemische Vernetzungsinitiatoren, Sensibilisierungsmittel, Netzhilfsmittel, Haftvermittler, Verlaufsmittel, Antioxidationsmittel, Stabilisatoren, Farbstoffe und photochrome oder thermochrome Verbindungen.

Bevorzugt enthält die Zusammensetzung polymerisierbare und/oder polykondensierbare Monomere, sowie mindestens ein biologisches Polymer, wobei die polymerisierbare und/oder polykondensierbare Monomere bezogen auf das Gewicht im Überschuss enthalten sind. Bevorzugt im Verhältnis von über 10:1, oder über 30:1, bevorzugt über 50:1, besonders bevorzugt über 100:1.

Desweiteren betrifft die Erfindung auch ein optisches Element mit Gradientenstruktur, wobei die Gradientenstruktur durch einen Brechzahlgradienten gebildet wird, enthaltend folgende Komponenten 2 bis 99.999 Gew.-% eines oder mehrerer Polymere und 0.001 Gew.-% bis 1 Gew.-% eines oder mehrerer biologischer Polymere, wobei das biologische Polymer DNA, RNA und/oder Derivate davon enthält. Bevorzugt sind 99 bis 99.999 Gew.-% eines oder mehrerer Polymere.

In einer vorteilhaften Weiterbildung der Erfindung sind das oder die Polymere ausgewählt aus der Gruppe enthaltend Poly-(meth)acrylsäure und Derivate, Poly(meth)acrylate, Poly-(meth)acrylnitrile, Polystyrole oder Polystyrol-Derivate, Polyalkene, halogenierte Polyalkene, Polyvinylacetat, Polyvinylpyrrolidon, Polyvinylcarbazol, Poly(polyethylenglycol)(meth)-acrylate, Poly(polyethylenglycol)di(meth)acrylate.

Bevorzugt sind es Polymere von Acrylaten oder Methacrylaten mit einer oder mehreren polymerisierbaren Gruppen, sogenannte Vernetzer, welche mit Oligomeren und / oder Polymeren modifiziert sind. Ganz besonders bevorzugt werden Monomere mit einem Molgewicht von bis zu 5000 g/mol, bevorzugt bis zu 1500 g/mol, besonders bevorzugt zwischen 27 g/mol und 600 g/mol. Beispiele für solche Acrylate oder Methacrylate sind Polyethylenglycoldi(meth)acrylate (PEGDMA), Polyethylenglycol(meth)acrylate (PEGMA), Tetramethelenglycoldi(meth)acrylate (TMGDMA), Bisphenyl-A-di(meth)acrylate (BPADMA) oder Tetraethylenglycoldi(meth)acrylate (TEGDMA).
In einer weiteren vorteilhaften Weiterbildung enthält das optische Element zusätzlich 0,1 bis 98 Gew.-% eines oder mehrerer organischer Polymere ausgewählt aus der Gruppe enthaltend Polyacrylate, Polymethacrylate, Polyepoxide, Polyvinyle, Polyethylene, Polyethylenglycole, Polystyrole oder Polystyrol-Derivate, Polyalkene, halogenierte Polyalkene, Polyvinylacetat, Polyvinylpyrrolidon oder Polyvinylcarbazol.

Bevorzugt enthält das optische Element 49 bis 98.999 Gew.-% eines oder mehrerer Polymere und 1 Gew.-% bis 50 Gew.-% des zusätzlichen Polymers eines mindestens eines Polymers.

In einer weiteren vorteilhaften Weiterbildung enthält das optische Element zusätzlich 0,1 bis 98 Gew.-% einer gehärteten Matrix aus Polymeren und / oder aus Kondensat aus hydrolysierbaren Silanen, welche auch polymerisierbare und / oder polykondensierbare Gruppen aufweisen können. Beispiele für solche Kondensate finden sich in WO 03/058292, auf die hiermit explizit Bezug genommen wird.

Im Falle von Polymeren sind Polyurethanharz-Lacke und Polyepoxidharz-Lacke bevorzugt.

In eine weiteren vorteilhaften Weiterbildung enthält das optische Element zusätzlich noch nanoskalige Teilchen, welche gegebenenfalls oberflächenmodifizierte oberflächenmodifiziert sind. Beispiele für geeignete Teilchen, welche gegebenenfalls oberflächenmodifiziert sind, finden sich in WO 03/058292, auf die hiermit explizit Bezug genommen wird.

Bevorzugt sind allerdings Zusammensetzungen aus lediglich organischen Komponenten ohne Metallkomplexe oder anorganische Nanopartikel.

Bevorzugt ist ein optisches Element nach dem erfindungsgemäßen Verfahren.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

Die Komponenten zur Herstellung der Zusammensetzung bzw. einer Vorstufe davon können in beliebiger Weise und Reihenfolge miteinander gemischt werden.

Für die Beschichtung werden vorzugsweise für optische Anwendungen geeignete Substrate ausgewählt, wie beispielsweise Glas, Keramik, Silicium, Metall, Halbleiter-Materialien oder (vorzugsweise transparente) Kunststoffe, wie PET, PE und PP. Ein besonders bevorzugtes Substrat ist eine Kunststofffolie. Die Beschichtung kann nach üblichen Methoden erfolgen, z. B. durch Tauchen, Fluten, Rakeln, Gießen, Schleudern, Spritzen, Aufstreichen, Slot-Coating, Meniskus-Coating, Foliengießen, Spinnen oder Sprühen. Hierfür eignen sich natürlich flüssige Vorstufen der Zusammensetzung, wobei die erforderliche Viskosität beispielsweise durch Zugabe oder Entfernen von Lösungsmittel(n) eingestellt werden kann. Bevorzugte Schichtdicken (der fertigen Beschichtung) liegen bei 0,2 bis 300 µm, besonders bevorzugt zwischen 0,2 bis 100 µm.

In dieser Form kann das Folienmaterial aufgewickelt, lichtgeschützt und klimatisiert (15 bis 30 °C) zwischengelagert werden. Auf diese Weise kann auch ein Folienverbund bzw. -komposit hergestellt werden. Folien mit einer Beschichtung, die einen Brechzahlgradienten aufweist, auf die gegebenenfalls eine zweite Folie auflaminiert wurde (Folienkomposit) sind bevorzugte erfindungsgemäße optische Elemente.

Mit Vorteil kann die Zusammensetzung vor der Belichtung noch getrocknet werden.

Anschließend wird in der Zusammensetzung auf die oben beschriebene Weise eine Potentialdifferenz erzeugt, so dass durch gerichtete Diffusion und der induzierten lokalen Polymerisation oder Polykondensation ein Brechzahlgradient gebildet wird. Die Potentialdifferenz wird bevorzugt durch ein Belichtungsverfahren erzeugt.

Die sich bei Erzeugung einer Potentialdifferenz abspielenden Vorgänge werden nachstehend für eine bevorzugte Ausführungsform erläutert.

Durch eine lokale Belichtung polymerisieren die Monomere der Zusammensetzung zu Polymeren. Dabei können sowohl lineare, wie auch verzweigte Polymere entstehen. Dadurch wird ein chemischer Potentialgradient für noch nicht polymerisierte Monomere zu der unbelichteten Nachbarregion gebildet. Aus dieser Nachbarregion diffundieren daher weitere Monomere in die belichtete Region. Dieser Prozess kann während und nach der Belichtung erfolgen und dauert zwischen wenigen Sekunden bis wenige Minuten, je nach Belichtungsbedingungen und Temperatur. Durch den Brechzahlunterschied zwischen den verschiedenen Bereichen mit unterschiedlicher Polymerisation entsteht auf diese Weise ein lokaler Brechzahlgradient.

Die gegebenenfalls zugegebenen Vorläufer der härtbaren Matrix können sowohl vor dem Anlegen der Potentialdifferenz, während, als auch nach dem Anlegen der Potentialdifferenz gehärtet werden, bevorzugt nach dem Anlegen der Potentialdifferenz.

Zusammengefasst erlaubt das erfindungsgemäße Verfahren auf eine kostengünstige und effiziente Weise die Herstellung von Gradientenstrukturen durch die Verwendung von biologischen Polymeren.

Das erfindungsgemäße Verfahren eignet sich insbesondere zur Herstellung von optischen Elementen mit einem Brechzahlgradienten. Die optischen Elemente sind insbesondere als holographische Anwendungen, Lichtmanagementfolien, Diffusoren, planare Gradientenindexlinsen in der abbildenden Optik, Head-up-Displays, Head-down-Displays, Lichtwellenleiter, vor allem in der optischen Nachrichten- und Übertragungstechnik, und optische Datenspeicher geeignet. Beispiele für herstellbare optische Elemente sind Sicherheitshologramme, Bildhologramme, digitale Hologramme zur Informationsspeicherung, Systeme mit Komponenten, die Lichtwellenfronten verarbeiten, planare Wellenleiter, Strahlteiler und Linsen.

In einer bevorzugten Ausführungsform der Erfindung zur Herstellung eines Transmissionshologramms wird eine solche erfindungsgemäße Zusammensetzung auf eine Glasoberfläche aufgetragen und getrocknet. Dabei wurden Schichten mit einer Dicke zwischen 8 und 200 µm hergestellt. Mit Hilfe von Zwei-Wellenmischen eines Laserstrahls mit einer Wellenlänge zwischen 300 nm und 500 nm und einer Intensität zwischen 7 und 300 mW/cm² werden phasenmodulierte Volumenhologramme sowohl als Transmissions- als auch als Reflexionshologramme erzeugt. Die Belichtungszeit beträgt zwischen 1 Sekunden und 10 Minuten, bevorzugt zwischen 2 und 6 Minuten.

Ein weiterer besonderer Aspekt der Erfindung liegt in der zusätzlichen Nutzung der beispielsweise in DNA enthaltenen Sequenzinformation als zusätzliches Sicherheitsmerkmal in dem hergestellten optischen Element.
- Fig. 1: Experimenteller Aufbau zur Erzeugung und Untersuchung der Hologramme;
- Fig. 2: Gemessene Intensität während der Messung;
- Fig. 3a: Lichtmikroskopische Aufnahme eines erhaltenen Hologramms;
- Fig. 3b: Ausschnittsvergrößerung aus 3a;
- Fig. 4: Vergleich verschiedener Belichtungsbedingungen (normiert auf einen gemeinsamen Startwert);
- Fig. 5: Vergleich von Proben mit und ohne DNA (normiert auf einen gleichen Startwert);
- Fig. 6: Vergleich von Proben mit und ohne DNA (normiert auf einen gleichen Startwert)

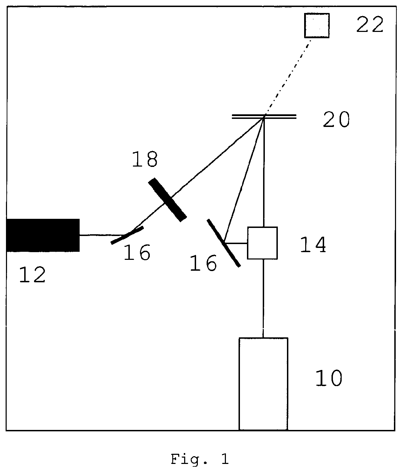

Fig. 1 zeigt den verwendeten Aufbau zur Erzeugung der Hologramme. Zum Schreiben wurde ein Ar⁺-Ionenlaser (λ= 351 nm, 10) verwendet. Der Schreibprozess kann durch einen He-Laser (λ=632,9 nm 12) kontrolliert werden. Das Hologramm selbst wurde mittels eines Strahlteilers (14) im Strahlengang des Ar⁺-Ionenlasers (10) erzeugt. Diese Strahlen und der Strahl des He-Lasers (12) wurden über mehrere Spiegel (16) auf die Probe (20) geleitet. Zur Detektion des Hologramms mit Hilfe des He-Lasers (12, moduliert auf 124 Hz mittel eines Choppers (18)) wurde ein Detektor mit Anschluss an einen Lock In Amplifier (22, Stanford Research Systems SR 850 DSP) verwendet.

### Herstellung von lipophiler DNA

Zur Herstellung lipophiler DNA wurden 2,00 g DNA (Sigma Aldrich, gewonnen aus Heringssperma) in 98,0 g reinst. Wasser 30 min bei 70°C inkubiert, danach 24h gerührt und dann mit Hilfe von steriler Cellulose (0,2µm) gefiltert.
Ansatz der CTMA (Cetyltrimehylammoniumchlorid) -H₂O-Lösung: 1,92 g CTMA werden in 100 ml reinst. H₂O gelöst und für 24h gerührt.

Die Lösungen wurden 1:1 gemischt (jeweils 50 ml) und ca.15 min gerührt. Die Fällungsreaktion setzte sofort ein. Der Niederschlag wurde abfiltriert, mit reinst. H₂O gewaschen und dann im Trockenschrank bei 37°C über 3 Tage getrocknet (Ausbeute: 1,09 g). Die Ausbeute wurde mit Hilfe eines Mörsers pulverisiert und sodann wurden 100 mg des DNA-CTMA-Komplexes in 10,0 ml 2-Propanol gelöst. Diese Lösung wurde für die Versuche eingesetzt.

### Herstellen der Zusammensetzung

Als Matrixmaterial wurde Polyvinylacetat (PVAc) Synthomer M 50 verwendet, dazu wurden 5,20 g PVAc in 15,0 ml Aceton gelöst. Zu 2,00 ml dieser Lösung wurden 2,00 ml Tetraethylenglycoldimethacrylat (TEGDMA, tech. 90 %) gegeben und danach 2,00 ml der DNA-CTMA- 2-Propanol-Lösung. Es bildet sich eine leichte weiße Trübung.

Als Blindproben wurden analog hergestellte Lösungen, aber zum einen ohne DNA-CTMA und zum anderen mit DNA-CTMA, aber ohne TEGDMA verwendet.

### Herstellung der Filme

Auf einem Glasobjektträger (Marienfeld) wurden mehrere Tropfen der jeweiligen Sole aufgebracht und anschließend für 1 min mit Warmluft getrocknet. Anschließend wurden Aluminiumfolienstreifen mit einer Dicke von ∼ 10 - 12 µm als Abstandhalter aufgelegt und die Proben mit einem weiteren Objektträger abgedeckt.

### Erzeugung der Hologramme

### Beispiel 1

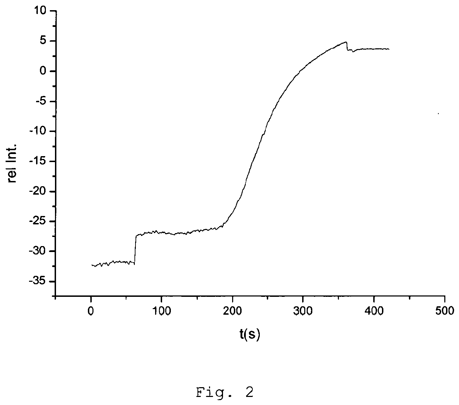

Eine Zusammensetzung mit CTMA-DNA, PVAc und TEGDMA wurde vor Beginn der Belichtung 1 min ruhen gelassen, dann 5 min belichtet und anschließend 1 min wieder ruhen lassen. Fig. 2 zeigt den Verlauf der gemessenen Intensität. Die Laserintensität betrug 18,5 mW 264 mW / cm².

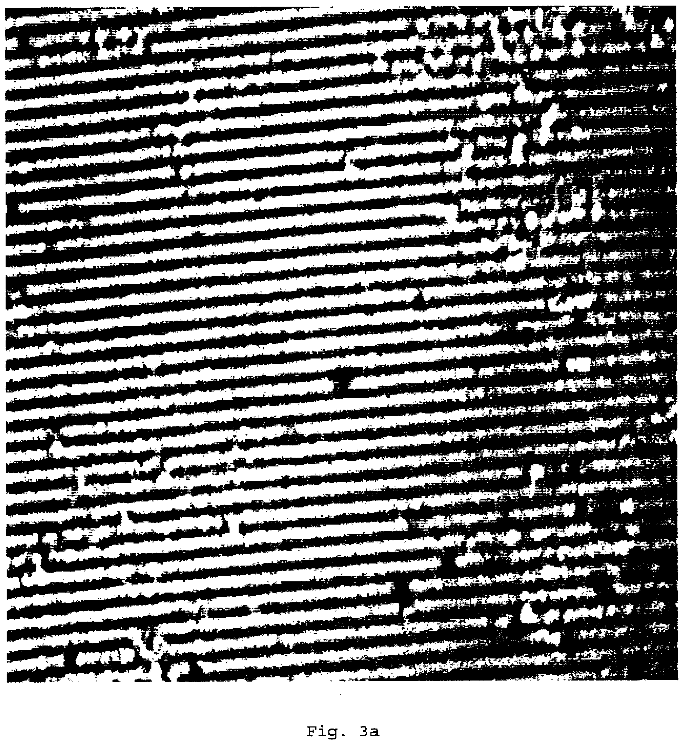

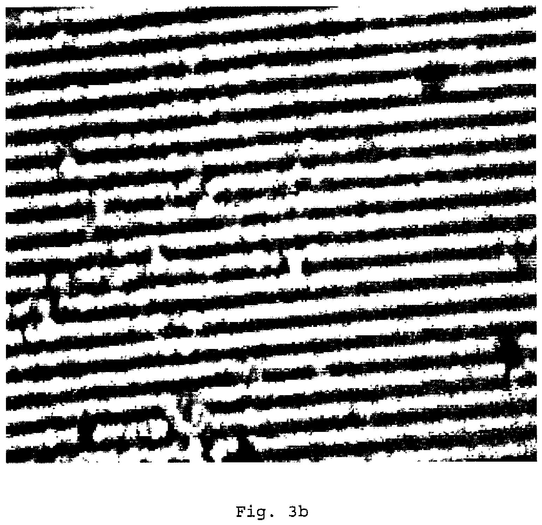

Es wurde ein Hologramm mit je 2 Beugungsmaxima erhalten. Fig. 3a zeigt das erhaltene Hologramm unter einem Lichtmikroskop. Der Abstand zwischen den Linien beträgt von Mitte zu Mitte 10 µm, die Breite der Linien beträgt etwa 2 µm. Beugungswirkungsgrad η = 2,2%. Fig. 3b zeigt eine Ausschnittsvergrößerung von Fig. 3a.

### Vergleichsbeispiel 1:

Unter den Bedingungen von Beispiel 1 wurde eine Zusammensetzung ohne CTMA-DNA belichtet. Es wurde kein Hologramm erhalten.

### Vergleichsbeispiel 2:

Eine Zusammensetzung nach Beispiel 1 aber ohne TEGDMA wurde 1 min ruhen lassen, dann 5 min belichtet und anschließend 1 min wieder ruhen lassen. Die Laserleistung betrug 19,3 mW (-276 mW/cm²). Es wurde kein Hologramm erhalten.

### Beispiel 2:

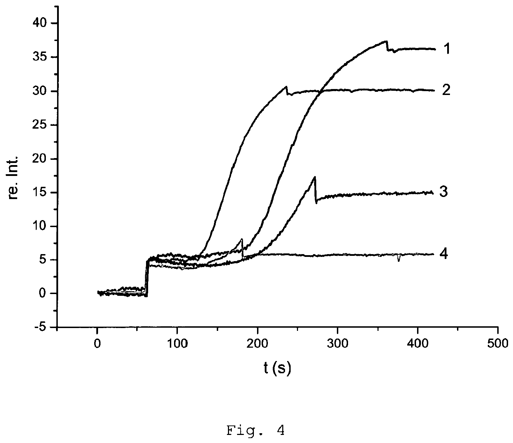

Die Zusammensetzung aus Beispiel 1 wurde unter unterschiedlichen Bedingungen belichtet. Fig. 4 zeigt die gemessenen Intensitäten (normiert auf einen gemeinsamen Startwert):

| Probe | Ruhen | Belichtung | Ruhen |
|---|---|---|---|
| 1 | 1 min | 5 min | 1 min |
| 2 | 1 min | 3 min | 3 min |
| 3 | 1 min | 3,5 min | 2,5 min |
| 4 | 1 min | 2 min | 4 min |

### Beispiel 3

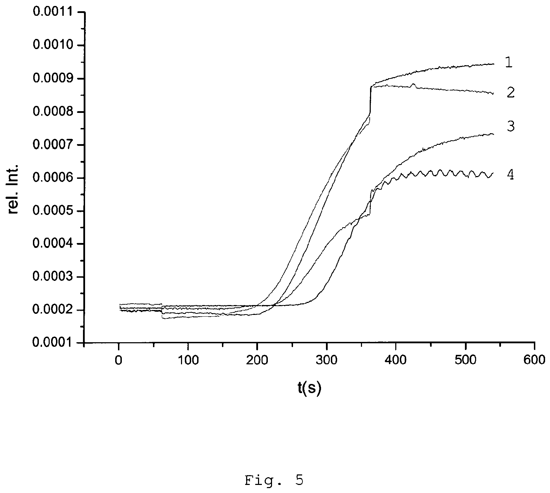

In einem weiteren Versuch wurden die Mischungen nach Beispiel 1 mit und ohne DNA auf einen Objektträger aufgebracht und für 1h bei 70°C getrocknet. Anschließend wurden wieder Al-Abstandhalter und ein weiterer Objektträger aufgelegt und die Proben untersucht. Es wurde 1 min ruhen gelassen und anschließend 5 min belichtet, danach wurde 3 min lang ruhen gelassen. Die Laserleistung betrug 19,3 mW (Fig. 5). Zwar wird ohne DNA auch ein Hologramm erhalten (Kurve 4), aber die Proben mit DNA - gemessen an verschiedenen Stellen der Proben (Kurven 1-3) - besitzen eine deutlich höhere Qualität und reagieren wesentlich schneller.

### Beispiel 4

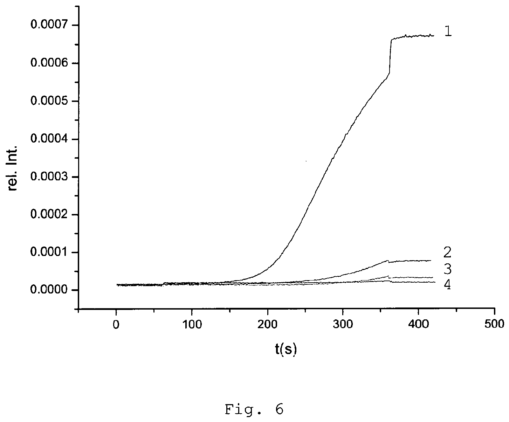

In diesem Experiment wurden Zusammensetzung nach Beispiel 1 samt Abstandhalter und Objektträger bei 100°C für 30 min im Trockenschrank belassen und anschließend wie in Beispiel 1 untersucht (1 min / 5 min / 1 min; Laserleistung 19,3 mW, Fig. 6). Die Probe mit DNA (Kurve 1) ist deutlich zu erkennen. Die Proben ohne DNA (Kurven 2 - 4)wurden an mehreren Stellen vermessen.

### Bezugszeichen

- 10: Ar⁺-Ionenlaser
- 12: He-Laser
- 14: Strahlteiler
- 16: Spiegel
- 18: Chopper
- 20: Probe
- 22: Detektor mit Anschluss an einen Lock in Amplifier

### Liste der zitierten Literatur:

WO 2008-004203
US 2005-0008762
WO 03/058292
DE-A-19719948
DE-A- 19746885
EP-B-636111

## Patentansprüche

1. Verfahren zur Herstellung optischer Elemente mit Gradientenstruktur, wobei die Gradientenstruktur durch einen Brechzahlgradienten gebildet wird mit folgenden Schritten:
(a) Herstellen einer Zusammensetzung aus einem oder mehreren polymerisierbaren und/oder polykondensierbaren Monomeren und mindestens einem biologischem Polymer, wobei das biologische Polymer in einer in der Zusammensetzung löslichen Form vorliegt;
(b) Erzeugen einer Potentialdifferenz zur gerichteten Diffusion der Monomere unter Bildung eines Brechzahlgradienten durch Induzierung einer lokalen Polymerisation oder Polykondensation.

2. Verfahren nach Anspruch 1, **dadurch gekennzeichnet, dass**
die Potentialdifferenz durch Belichten, vorzugsweise mit UV-Licht, Laserlicht und/oder durch Elektronenbestrahlung erzeugt wird.

3. Verfahren nach Anspruch 1 oder 2, **dadurch gekennzeichnet, dass**
die Potentialdifferenz durch holographische oder lithographische Techniken erzeugt wird.

4. Verfahren nach einem der vorhergehenden Ansprüche, **dadurch gekennzeichnet, dass**
das biologische Polymer Nukleobasen und/oder Derivate von diesen enthält.

5. Verfahren nach einem der vorhergehenden Ansprüche, **dadurch gekennzeichnet, dass**
das biologische Polymer DNA, RNA und/oder Derivate davon enthält.

6. Verfahren nach einem der vorhergehenden Ansprüche, **dadurch gekennzeichnet, dass**
das polymerisierbare und/oder polykondensierbare organische Monomer oder die polymerisierbaren und/oder polykondensierbaren organischen Monomere ausgewählt sind aus der Gruppe enthaltend (Meth)acrylsäure und Derivate, (Meth)acrylsäureester und Derivate, (Meth)acrylnitrile, Styrole oder Styrol-Derivate, Alkene, halogenierte Alkene, Vinylacetat, Vinylpyrrolidon oder Vinylcarbazol.

7. Verfahren nach einem der vorhergehenden Ansprüche, **dadurch gekennzeichnet, dass**
die Zusammensetzung mindestens ein organisches Polymer ausgewählt aus der Gruppe Poly(meth)acrylsäure und Derivate, Poly(meth)acrylate, Poly(meth)acrylnitrile, Polystyrole oder Polystyrol-Derivate, Polyalkene, halogenierte Polyalkene, Polyvinylacetat, Polyvinylpyrrolidon, Polyvinylcarbazol, Poly(polyethylenglycol)-(meth)acrylate, Poly(polyethylenglycol)di(meth)acrylate enthält.

8. Optisches Element mit Gradientenstruktur, wobei die Gradientenstruktur durch einen Brechzahlgradienten gebildet wird, enthaltend folgende Komponenten:
(a) 2 bis 99,999 Gew.-% eines oder mehrerer Polymere;
(b) 0,001 Gew. -% bis 1 Gew.-% eines biologischen Polymers, wobei das biologische Polymer DNA, RNA und/oder Derivate davon enthält.

## Claims

1. A process for producing optical elements with gradient structure, said gradient structure being formed by a refractive index gradient, comprising the following steps:
(a) preparing a composition composed of one or more polymerizable and/or polycondensable monomers and at least one biological polymer, whereas the biological polymer is in a form which is soluble in the composition;
(b) generating a potential difference for directed diffusion of the monomers to form a refractive index gradient by inducing local polymerization or polycondensation.

2. The process as claimed in claim 1, **characterized in that** the potential difference is generated by exposure, preferably with UV light, laser light and/or by electron irradiation.

3. The process as claimed in claim 1 or 2, **characterized in that** the potential difference is generated by holographic or lithographic techniques.

4. The process as claimed in any of the preceding claims, **characterized in that** the biological polymer comprises nucleobases and/or derivatives thereof.

5. The process as claimed in any of the preceding claims, **characterized in that** the biological polymer comprises DNA, RNA and/or derivatives thereof.

6. The process as claimed in any of the preceding claims, **characterized in that** the polymerizable and/or polycondensable organic monomer or the polymerizable and/or polycondensable organic monomers is/are selected from the group comprising (meth)acrylic acid and derivatives, (meth)acrylic ester and derivatives, (meth)acrylonitriles, styrenes or styrene derivatives, alkenes, halogenated alkenes, vinyl acetate, vinylpyrrolidone or vinylcarbazole.

7. The process as claimed in any of the preceding claims, **characterized in that** the composition comprises at least one organic polymer selected from the group of poly(meth)acrylic acid and derivatives, poly(meth)acrylates, poly(meth)-acrylonitriles, polystyrenes or polystyrene derivatives, polyalkenes, halogenated polyalkenes, polyvinyl acetate, polyvinylpyrrolidone, polyvinylcarbazole, poly(polyethylene glycol) meth-(acrylates), poly(polyethylene glycol) di(meth)-acrylates.

8. An optical element with gradient structure, said gradient structure being formed by a refractive index gradient, comprising the following components:
(a) 2 to 99.999% by weight of one or more polymers;
(b) 0.001% by weight to 1% by weight of a biological polymer, whereas the biological polymer comprises DNA, RNA and/or derivatives thereof.

## Revendications

1. Procédé pour la fabrication d'éléments optiques présentant une structure à gradient, la structure à gradient étant formée par un gradient d'indices de réfraction, présentant les étapes suivantes :
(a) préparation d'une composition constituée par un ou plusieurs monomères polymérisables et/ou polycondensables et au moins un polymère biologique, le polymère biologique se trouvant sous une forme soluble dans la composition ;
(b) génération d'une différence de potentiel pour la diffusion ciblée des monomères avec formation d'un gradient d'indices de réfraction par induction d'une polymérisation locale ou d'une polycondensation locale.

2. Procédé selon la revendication 1, **caractérisé en ce que** la différence de potentiel est générée par un éclairage, de préférence par de la lumière UV, de la lumière laser et/ou par un rayonnement électronique.

3. Procédé selon la revendication 1 ou 2, **caractérisé en ce que** la différence de potentiel est générée par des techniques holographiques ou lithographiques.

4. Procédé selon l'une quelconque des revendications précédentes, **caractérisé en ce que** le polymère biologique contient des nucléobases et/ou des dérivés de celles-ci.

5. Procédé selon l'une quelconque des revendications précédentes, **caractérisé en ce que** le polymère biologique contient de l'ADN, de l'ARN et/ou des dérivés de ceux-ci.

6. Procédé selon l'une quelconque des revendications précédentes, **caractérisé en ce que** le monomère organique polymérisable et/ou polycondensable ou les monomères organiques polymérisables et/ou polycondensables est/sont choisis dans le groupe contenant l'acide (méth)acrylique et dérivés, les esters de l'acide (méth)acrylique et dérivés, les (méth)acrylonitriles, les styrènes ou les dérivés du styrène, les alcènes, les alcènes halogénés, l'acétate de vinyle, la vinylpyrrolidone ou le vinylcarbazole.

7. Procédé selon l'une quelconque des revendications précédentes, **caractérisé en ce que** la composition contient au moins un polymère organique choisi dans le groupe contenant le poly(acide (méth)acrylique) et dérivés, les poly(méth)acrylates, les poly(méth)acrylonitriles, les polystyrènes ou les dérivés du polystyrène, les polyalcènes, les polyalcènes halogénés, le poly(acétate de vinyle), la polyvinylpyrrolidone, le polyvinylcarbazole, les poly((méth)acrylates de polyéthylèneglycol), les poly(di(méth)acrylates de polyéthylèneglycol).

8. Élément optique présentant une structure à gradient, la structure à gradient étant formée par un gradient d'indices de réfraction, contenant les composants suivants :
(a) 2 à 99,999% en poids d'un ou de plusieurs polymères ;
(b) 0,001% en poids à 1% en poids d'un polymère biologique, le polymère biologique contenant de l'ADN, de l'ARN et/ou des dérivés de ceux-ci.
